(19) Europäisches Patentamt
European Patent Office
Office européen des brevets

(11) **EP 2 019 505 A2**

(12) **EUROPEAN PATENT APPLICATION**

(43) Date of publication:
**28.01.2009 Bulletin 2009/05**

(51) Int Cl.:
***H04L 1/00*** (2006.01)

(21) Application number: **08159895.5**

(22) Date of filing: **08.07.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **11.07.2007 JP 2007182294**

(71) Applicant: **Sony Corporation**
**Minato-ku**
**Tokyo (JP)**

(72) Inventor: **Ichiki, Shoji**
**c/o SONY CORPORATION**
**TOKYO (JP)**

(74) Representative: **Thévenet, Jean-Bruno et al**
**Cabinet Beau de Loménie**
**158, rue de l'Université**
**75340 Paris Cédex 07 (FR)**

(54) **Transmitting apparatus, receiving apparatus, error correcting system, transmitting method, and error correcting method**

(57)    A transmitting apparatus includes a generating unit (15) and a transmitting unit (17). The generating unit (15) generates first error correction packets by performing predetermined operation processing on a plurality of data packets arranged in a plurality of rows and columns respectively in each of the rows and columns and generating at least one second error correction packet by performing the predetermined operation processing on the data packets existing in a diagonal direction crossing the plurality of rows and columns. The transmitting unit (17) transmits the plurality of data packets and the generated first and second error correction packets.

FIG.1

## Description

CROSS REFERENCES TO RELATED APPLICATIONS

The present invention contains subject matter related to Japanese Patent Application JP 2007-182294 filed in the Japanese Patent Office on July 11, 2007, the entire contents of which being incorporated herein by reference.

Background of the Invention

1. Field of the Invention

The present invention relates to a transmitting apparatus transmitting error correction packets in addition to data packets, a receiving apparatus receiving the data packets and the error correction packets, an error correcting system using the transmitting apparatus and the receiving apparatus, a transmitting method performed in the transmitting apparatus, and an error correcting method performed in the receiving apparatus.

2. Description of the Related Art

In recent years, attention has been given to a television broadcasting service (IPTV) which provides contents using an IP (Internet Protocol) instead of airwaves. In this IPTV, in addition to broadcast contents to be downloaded by a receiving apparatus, there are broadcast contents to be delivered by streaming to the receiving apparatus. Streaming requires real-time performance, so in the IPTV, instead of a TCP (Transmission Control Protocol) which attaches importance to reliability, an RTP (Real-time Transport Protocol) which attaches importance to real-time performance is used, and further in order to support multicast transmission, an UDP (User Datagram Protocol) is used.

When the RTP is used, unlike the TCP, it may be impossible that, to an unreceived packet out of packets (hereinafter referred to as media packets) constituting a content data stream, NACK (Negative AcKnowledgment) is returned and the unreceived media packet is retransmitted. Accordingly, if the media packet is lost, the receiving apparatus decodes data while a portion corresponding to the lost media packet remains hidden, which causes distorted video and audio. In particular, in recent years, the Internet penetration rate has extremely increased, so it is expected that the communication becomes congested and that media packets become lost. Hence, there is error correction technology in which on the transmitting server side, when media packets are transmitted, an FEC (Forward Error Correction) packet for protecting a certain number of media packets is transmitted as a redundant packet with the media packets, and on the receiving apparatus side, the lost media packet is restored using this FEC packet.

This FEC packet is obtained by, for example, XORing (eXclusive ORing) a plurality of media packets. More specifically, for example, there is a method for generating an FEC packet by XORing all of a plurality of adjacent media packets (with continuous sequence numbers). In other words, this method is FEC processing of media packets in a one-dimensional (linear) direction. In this one-dimensional processing, however, when an error occurs in two or more media packets out of the plurality of media packets subjected to the XOR operation in a burst manner, the two or more media packets are difficult to be restored.

Therefore, the Pro-MPEG Forum proposes a method in which in Pro-MPEG COP (Code of Practice) #3 release 2, a plurality of media packets are treated two-dimensionally by being arranged in D rows and L columns and FEC packets corresponding to the sum of the number of rows (D) and the number of columns (L) are generated by XORing the media packets in a row direction (lateral direction) and a column direction (longitudinal direction) respectively. Thus, for example, even if a burst error occurs in media packets included in one row (column), the media packets can be restored by the FEC packet in the column (row) direction. Also in Japanese Patent Application Publication No. 2007-509557 (Fig. 1, etc.), this method of Pro-MPEG COP #3 release 2 is described.

Summary of the Invention

In the two-dimensional processing described in Japanese Patent Application Publication No. 2007-509557 (Fig. 1, etc.), however, for example, when four lost packets which form respective vertexes of a rectangle occur in the row and column directions, two lost packets occur in each of the row and column directions, whereby these lost packets cannot be restored even if any packet is used. That is to say, by losing at least four media packets, all of these media packets may become unrestorable.

In view of the above circumstances, it is desirable to provide a transmitting apparatus, a receiving apparatus, an error correcting system, a transmitting method, and an error correcting method capable of improving the restoration rate of lost packets.

According to an embodiment of the present invention, there is provided a transmitting apparatus including generating means and transmitting means. The generating means generates first error correction packets by performing predetermined operation processing on a plurality of data packets arranged in a plurality of rows and columns respectively in each of the rows and columns and generating at least one second error correction packet by performing the predetermined operation processing on the data packets existing in a diagonal direction crossing the plurality of rows and columns. The transmitting means transmits the plurality of data packets and the generated first and second error correction packets.

The data packet here refers to, for example, a media packet constituting multimedia data such as a video content, au audio content, a text content, or a Web content. The first and second error correction packets refer to, for example, FEC packets, and the predetermined operation processing refers to, for example, XOR operation processing, but another function such as a Read-Solomon code or a Hamming code may be used. This transmitting apparatus functions as a server apparatus on a network which distributes, for example, the above various contents.

With this constitution, by adding the second error correction packet in the diagonal direction in addition to the first error correction packets, the number of patterns in which the lost data packets can be restored in the receiving apparatus can be dramatically increased while an increase in the data amount of the error correction packets is reduced to a minimum.

In the above transmitting apparatus, the generating means may generate the second error correction packets respectively by performing the predetermined operation processing respectively on a plurality of first data packets existing in a first diagonal direction and a plurality of second data packets existing in a second diagonal direction orthogonal to the first diagonal direction out of the plurality of data packets.

Consequently, the number of patterns in which the lost data packets can be restored in the receiving apparatus can be further increased.

In the above transmitting apparatus, it is also possible that the plurality of data packets are arranged in D rows and L columns, and that the generating means forms L groups each formed by extracting D data packets in the diagonal direction from the plurality of data packets and performs the predetermined operation processing on each of the L groups to generate the L second error correction packets.

Thus, the second error correction packets are generated using all of the data packets arranged in D rows and L columns, so that the number of patterns in which the lost data packets can be restored in the receiving apparatus can be further markedly increased.

The above transmitting apparatus may further include receiving means for receiving congestion information indicating a congestion status of a network from a receiving apparatus connected via the network, and the generating means may include means for regulating the generation of the second error correction packet based on the congestion information.

Consequently, the generation of the second error correction packet is regulated according to the congestion status of the network, so that the load on the transmitting apparatus caused by the generation can be reduced.

According to another embodiment of the present invention, there is provided a receiving apparatus connected to a transmitting apparatus via a network. The receiving apparatus includes receiving means, specifying means, and restoring means. The receiving means receives a plurality of data packets, first error correction packets generated by performing predetermined operation processing on the plurality of data packets arranged in a plurality of rows and columns respectively in each of the rows and columns, and at least one second error correction packet generated by performing the predetermined operation processing on the data packets existing in a diagonal direction crossing the plurality of rows and columns from the transmitting apparatus. The specifying means specifies a lost data packet lost out of the plurality of data packets. The restoring means restores the specified lost data packet using the first and second error correction packets.

Examples of the receiving apparatus here include all kinds of electronic apparatuses such as a television apparatus, a PC (Personal Computer), a recording/reproducing apparatus such as an HDD (Hard Disk Drive)/DVD (Digital Versatile Disk)/BD (Blu-ray Disc) recorder, a game machine, a cellular phone handset, and other AV (Audio/Video) devices. Owing to this constitution, even when the loss of a data packet occurs, the lost data packet can be restored with a high probability using not only the first error correction packet but also the second error correction packet.

In the above receiving apparatus, the restoring means may include means for arranging the received plurality of data packets in the plurality of rows and columns, means for detecting numbers of the lost data packets in a direction of each of the rows, a direction of each of the columns, and the diagonal direction, means for, when the number detected in the direction of each of the rows or direction of each of the columns is one, restoring the lost data packet by performing the predetermined operation processing on data packets other than the lost data packet in the direction of each of the rows or the direction of each of the columns and the first error correction packet, and means for, when the number detected in the diagonal direction is one, restoring the lost data packet by performing the predetermined operation processing on data packets other than the lost data packet in the diagonal direction and the second error correction packet.

For example, when four lost data packets occur so as to form respective vertexes of a rectangle in the above rows and columns, these lost data packets cannot be restored only by the first error correction packets, but when one lost data packet out of these four exists in the above diagonal direction, it becomes possible, owing to the above constitution, to restore the one lost data packet by the above second error correction packet and sequentially restore the remaining lost data packets by the above first error correction packets, thereby restoring all of the lost data packets.

In the above receiving apparatus, the received second error correction packets may be ones respectively generated by performing the predetermined operation processing respectively on a plurality of first data packets existing in a first diagonal direction and a plurality of second data packets existing in a second diagonal direction orthogonal to the first diagonal direction out of the plurality of data packets arranged in the plurality of rows and columns.

Thus, the receiving apparatus can restore further more patterns of lost data packets.

Further, in the above receiving apparatus, the received second error correction packets may be L second error correction packets generated by forming the L groups each formed by extracting D data packets in the diagonal direction from the plurality of data packets arranged in D rows and L columns and performing the predetermined operation processing on each of the L groups in the transmitting apparatus.

Consequently, markedly more patterns of lost data packets can be restored.

In the above receiving apparatus, it is also possible that the receiving means receives a predetermined packet from the transmitting apparatus before receiving the data packets, the receiving apparatus further includes generating means for generating congestion information indicating a congestion status of the network based on a reception status of the received predetermined packet, and transmitting means for transmitting the generated congestion information to the transmitting apparatus, and that the restoring means includes means for, when the transmitting apparatus regulates the generation and transmission of the second error correction packet based on the congestion information, regulating the detection of the number of the lost data packets in the diagonal direction.

Thus, by transmitting the above congestion information, when the congestion degree of the network is low, the load on the transmitting apparatus related to the generation of the above second error correction packet can be reduced, and besides the load on the receiving apparatus when the lost data packet is restored using the second error correction packet can be reduced. Simultaneously therewith, the number of transmitted packets can be reduced to a minimum. The above congestion information is generated, for example, by measuring the loss rate, packet delay, jitter, and so on of the predetermined packet. The predetermined packet refers to, for example, an SR (Sender Report) packet in an RTCP (RTP Control Protocol), and in this case, the above congestion information is transmitted as an RR (Receiver Report) packet.

The above receiving apparatus may further include input means for inputting a user's manipulation to select any of a first mode in which the lost data packet is restored using the first and second error correction packets, a second mode in which the lost data packet is restored using the first error correction packet, and a third mode in which the lost data packet is not restored, and setting means for setting any of the first to third modes according to the input.

Consequently, by allowing the user to select and set any of the above first to third modes, the load on the processing performed by the above restoring means can be reduced as necessary. Further, the restoration processing of the lost data packet is made variable according to the user's request for the quality of reproduced data, the immediacy of reproduction, and so on, leading to an improvement in user's convenience.

According to another embodiment of the present invention, there is provided an error correcting system. The error correcting system includes a transmitting apparatus and a receiving apparatus. The transmitting apparatus has generating means for generating first error correction packets by performing predetermined operation processing on a plurality of data packets arranged in a plurality of rows and columns respectively in each of the rows and columns and generating at least one second error correction packet by performing the predetermined operation processing on the data packets existing in a diagonal direction crossing the plurality of rows and columns, and transmitting means for transmitting the plurality of data packets and the generated first and second error correction packets. The receiving apparatus has receiving means for receiving the transmitted plurality of data packets and the first and second error correction packets from the transmitting apparatus, specifying means for specifying a lost data packet lost out of the plurality of data packets, and restoring means for restoring the specified lost data packet using the first and second error correction packets.

According to another embodiment of the present invention, there is provided a transmitting method. The transmitting method includes generating first error correction packets by performing predetermined operation processing on a plurality of data packets arranged in a plurality of rows and columns respectively in each of the rows and columns, generating at least one second error correction packet by performing the predetermined operation processing on the data packets existing in a diagonal direction crossing the plurality of rows and columns, and transmitting the plurality of data packets and the generated first and second error correction packets.

According to another embodiment of the present invention, there is provided an error correcting method. The error correcting method includes receiving a plurality of data packets, first error correction packets generated by performing predetermined operation processing on the plurality of data packets arranged in a plurality of rows and columns respectively in each of the rows and columns, and at least one second error correction packet generated by performing the predetermined operation processing on the data packets existing in a diagonal direction crossing the plurality of rows and columns from a transmitting apparatus connected via a network, specifying a lost data packet lost out of the plurality of data packets, and restoring the specified lost data packet using the first and second error correction packets.

As described above, according to the embodiments of the present invention, the restoration rate of lost packets can be improved.

These and other objects, features and advantages of the present invention will become more apparent in light of the following detailed description of best mode embodiments thereof, as illustrated in the accompanying drawings. Brief Description of Drawings

Fig. 1 is a diagram showing a configuration of an error correcting system according to a first embodiment of the present invention;

Fig. 2 is a flowchart showing a flow of an operation when a server transmits a content in the first embodiment of the present invention;

Fig. 3 is a diagram showing a relationship between a media packet and an FEC packet in the first embodiment of the present invention;

Fig. 4 is a diagram showing a manner in which an FEC processor of the server generates the FEC packets in the first embodiment of the present invention;

Fig. 5 is a flowchart showing a flow of an operation when a TV receives and decodes the content in the first embodiment of the present invention;

Fig. 6 is a diagram showing a state in which media packets are lost in the first embodiment of the present invention;

Figs. 7A to 7D are diagrams each showing a manner in which the lost media packets are restored in the first embodiment of the present invention;

Fig. 8 is a diagram showing a manner in which the FEC processor of the server generates the FEC packets in a second embodiment of the present invention;

Fig. 9 is a diagram showing a state in which the media packets are lost in the second embodiment of the present invention;

Figs. 10A to 10H are diagrams each showing a manner in which the lost media packets are restored in the second embodiment of the present invention;

Fig. 11 is a table showing a comparison of the number of patterns in which the media packets become unrestorable among the related art, the first embodiment, and the second embodiment;

Fig. 12 is a diagram showing a manner in which the FEC processor of the server generates the FEC packets in a third embodiment of the present invention;

Fig. 13 is a flowchart showing a flow of an operation when the TV receives and decodes the content in the third embodiment of the present invention;

Fig. 14 is a diagram showing a state in which the media packets are lost in the third embodiment of the present invention;

Figs. 15A to 15D are diagrams each showing a manner in which the lost media packets are restored in the third embodiment of the present invention;

Fig. 16 is a diagram showing a setting screen for a user of the TV to select a level of FEC processing in a different embodiment of the present invention;

Fig. 17 is a sequence diagram showing a flow of the FEC processing according to a congestion status in the different embodiment of the present invention; and

Fig. 18 is a diagram showing a manner in which the server generates the FEC packets for respective groups in a diagonal direction when the numbers of rows and columns are different.

Description of Preferred Embodiments

Embodiments of the present invention will be described below with reference to the drawings.

(First Embodiment)

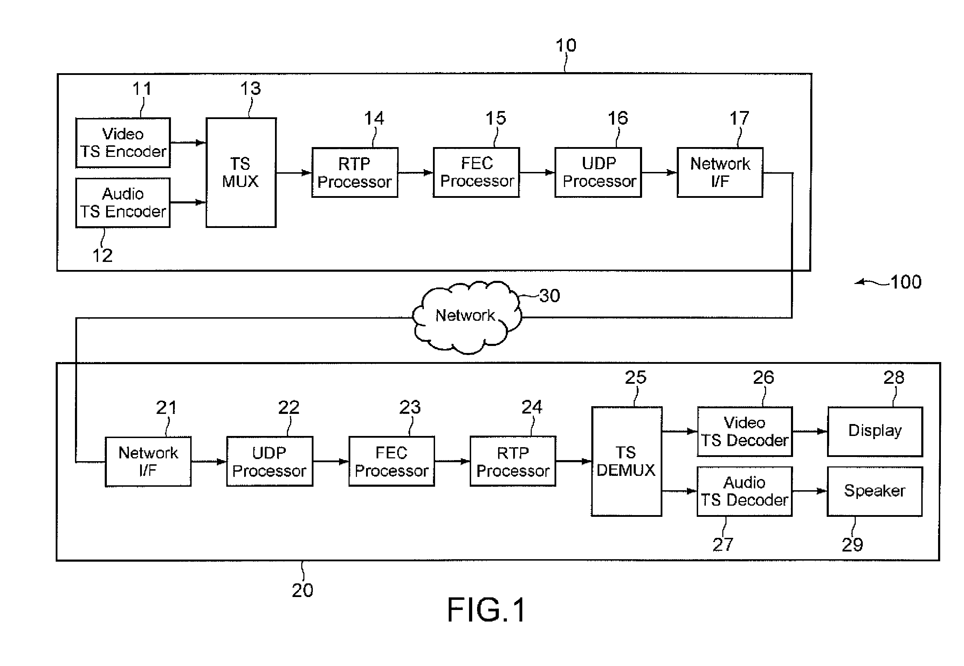

Fig. 1 is a diagram showing a configuration of an error correcting system according to a first embodiment of the present invention.

As shown in this figure, this error correcting system includes a server 10 serving as a transmitting apparatus and a television apparatus (hereinafter referred to as a TV) 20 serving as a receiving apparatus, both being connected to a network 30 such as the Internet, a leased line network, or a LAN (Local Area Network).

The server 10 includes a video TS (Transport Stream) encoder 11, an audio TS encoder 12, a TS-MUX (Multiplexer) 13, an RTP processor 14, an FEC processor 15, a UDP processor 16, and a network interface 17.

The video TS encoder 11 compression-encodes a video signal constituting a content as a video TS, for example, in a format such as MPEG (Moving Picture Expert Group)-2. The audio TS encoder 12 compression-encodes an audio signal constituting the content as an audio TS, for example, in a format such as MPEG-2. The TS-MUX 13 multiplexes the above compression-encoded video TS and audio TS.

Based on an RTP, the RTP processor 14 adds RTP headers to the above multiplexed TS to generate RTP packets (hereinafter also referred to as media packets). Using the generated RTP packets, the FEC processor 15 generates FEC packets serving as error correction packets. Based on an UDP, the UDP processor 16 packetizes the above RTP packets and FEC packets into UDP packets, respectively, by adding UDP headers thereto.

The network interface 17 transmits the UDP packets serving as the above RTP packets and FEC packets to the TV 20 via the network 30.

The TV 20 includes a network interface 21, a UDP processor 22, an FEC processor 23, an RTP processor 24, a TS-DEMUX 25, a video TS decoder 26, and an audio TS decoder 27 and is connected to a display 28 and a speaker 29.

The network interface 21 receives the above UDP packets transmitted from the server 10 via the network 30.

Based on the UDP, the UDP processor 22 analyzes the UDP headers of the received UDP packets and extracts the FEC packets and the RTP packets. Based on sequence numbers described in the RTP headers of the RTP packets, the FEC processor 23 specifies an RTP packet lost on the network 30 and restore the lost PTP packet using the above FEC packet. The RTP processor 24 analyzes the RTP headers of the received and restored RTP packets and adjusts the timing of reproduction of the content by time stamps and sequence numbers described in the RTP headers.

The TS-DEMUX 25 demultiplexes the above RTP packets into the video TS and the audio TS and outputs the video TS to the video TS decoder 26 and the audio TS to the audio TS decoder 27.

The video TS decoder 26 decodes the video TS inputted from the TS-DEMUX 25 in accordance with a compression encoding format such as MPEG-2 and outputs the video TS to the display 28 to display the video TS. The audio TS decoder 27 decodes the audio TS inputted from the TS-DEMUX 25 in accordance with a compression encoding format such as MPEG-2 and outputs the audio TS to the speaker 29 to reproduce the audio TS.

It is to be noted that, although not shown, the server 10 and the TV 20 each include a controller such as a CPU (Central Processing Unit), internal memories such as a ROM (Read Only Memory) and a RAM (Random Access Memory), and an input device such as a manipulation button, in addition to the above respective units. Further, when a download-type service is used, the TV 20 includes an external memory such as an HDD.

Next, an operation of the error correcting system thus configured will be described.

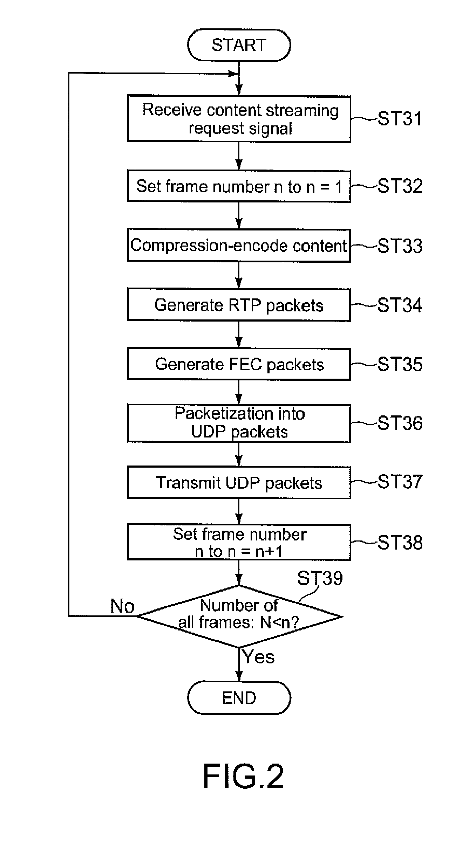

First, an operation of the server 10 will be described. Fig. 2 is a flowchart showing a flow of the operation of the server 10.

As shown in this figure, first, the server 10 receives a content streaming request signal from the TV 20 via the network 30 by the network interface 17, an example of the content being a moving image content (Step 31). The CPU of the server 10 sets a frame number n of a frame constituting the content to 1 in response to the request (Step 32), compression-encodes a video signal and an audio signal corresponding to the frame, respectively, by the video TS encoder 11 and the audio TS encoder 12, and multiplexes both the video and audio signals by the TS-MUX 13 (Step 33).

Subsequently, the CPU of the server 10 generates RTP packets (media packets) by the RTP processor 14 based on the video signal and the audio signal that have been compression-encoded and multiplexed, of the frame number 1 mentioned above (Step 34). Then, based on the media packets, the CPU generates FEC packets by the FEC processor 15 (Step 35). Further, the CPU packetizes the media packets and FEC packets into UDP packets (Step 36), and transmits the UDP packets to the TV 20 via the network 30 by the network interface 17 (Step 37). When the transmission is completed, the frame number n is incremented and set to n = n+1 (Step 38). The CPU repeats the above processing until the number of all frames N constituting the content satisfies N < n (Step 39).

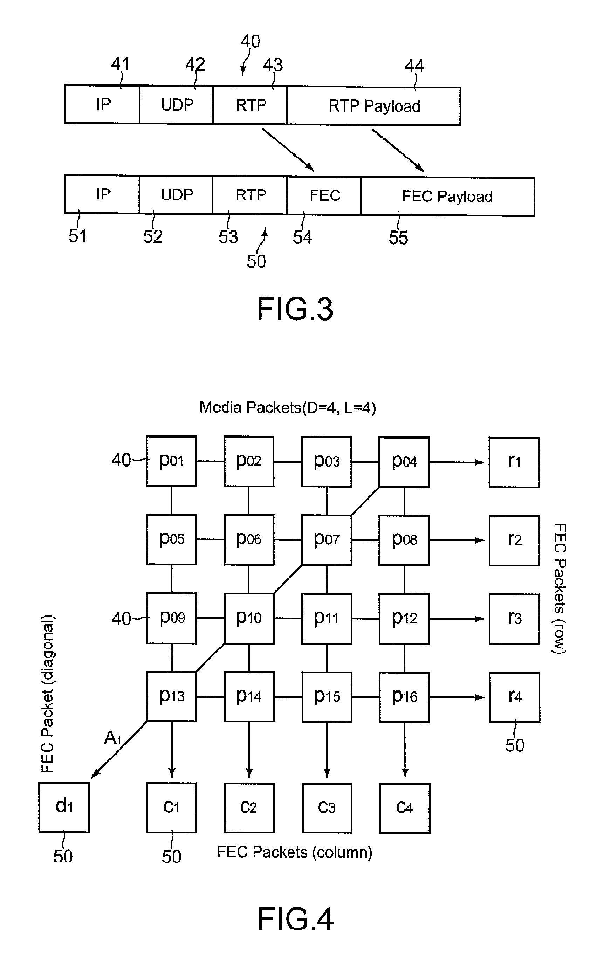

Fig. 3 is a diagram showing a relationship between the above media packet and FEC packet.

As shown in this figure, a media packet 40 includes an IP header 41, a UDP header 42, an RTP header 43, and a RTP payload 44. More specifically, the media packet 40 is brought into a state capable of being transmitted to the network 30 by the RTP processor 14 adding the RTP header 43 to the RTP payload 44 which is actual data on the compression-encoded video signal and audio signal, the UDP processor 16 in a lower layer adding the UDP header 42, and the network interface 17 in a further lower layer adding the IP header 41.

An FEC packet 50 includes an IP header 51, a UDP header 52, an RTP header 53, an FEC header 54, and an FEC payload 55. More specifically, the FEC processor 15 generates the FEC header 54 by XORing the RTP headers 43 of a plurality of media packets 40 and generates the FEC payload 55 by XORing respective RTP payloads 44 of the plurality of media packets 40. By adding the UDP header 52 and the IP header 51 to the FEC header 54 and FEC payload 55, the FEC packet 50 is brought into a state capable of being transmitted to the network 30.

Although not shown, respective IP addresses of the server 10 as a transmitting source and the TV 20 as a transmitting destination are included in the IP header 51 of the FEC packet 50, respective UDP port numbers of the server 10 as the transmitting source and the TV 20 as the transmitting destination are included in the UDP header 52, and the number of media packets 40 (numbers of rows and columns) and an FEC method (method for adding an FEC packet in a diagonal direction which will be described later) are described in the FEC header 54. This information is used when the lost media packet 40 is restored and decoded in the TV 20.

Fig. 4 is a diagram showing a manner in which the FEC processor 15 of the server 10 generates the FEC packets 50.

As shown in this figure, the FEC processor 15 arranges the media packets 40 in D rows and L columns. In this figure, by letting D = 4 and L = 4, a total of 16 media packets from $p_{01}$ to $p_{16}$ are arranged, but the numbers of rows and columns are not limited to these numbers of rows and columns.

The FEC processor 15 generates a plurality of FEC packets 50 by XORing these media packets 40 in D rows and L columns for each of the rows and columns. In this figure, for example, by sequentially XORing the media packets $p_{01}$, $p_{02}$, $p_{03}$, and $p_{04}$ included in the first row, an FEC packet $r_1$ in a row direction is generated, and by sequentially XORing media packets $p_{01}$, $p_{05}$, $p_{09}$, and $p_{13}$ included in the first column, an FEC packet $c_1$ in a column direction is generated.

Further, in this embodiment, the FEC processor 15 generates the FEC packet 50 in the diagonal direction in addition to the FEC packets 50 in the row and column directions. In other words, the FEC processor 15 generates an FEC packet $d_1$ in the diagonal direction by sequentially XORing the media packet $p_{04}$ at the uppermost row and the rightmost column and the media packets $p_{07}$, $p_{10}$, and $p_{13}$ existing in a diagonally downward left direction (direction of the arrow $A_1$ in this figure) from the media packet $p_{04}$.

Incidentally, in this figure, for convenience of description, D = 4 and L = 4 are assumed, but in an IPTV, the media packets 40 in the row and column directions are usually protected in units of 10 packets. For example, in Pro-MPEG COP #3 release 2 (hereinafter, Pro-MPEG 2D FEC) of the related art, with respect to 100 media packets in 10 rows and 10 columns, 10 FEC packets 50 in the row direction and 10 FEC packets 50 in the column direction are generated. Accordingly, in this embodiment, when the above FEC packet 50 in the diagonal direction is added by extending Pro-MPEG 2D FEC, one FEC packet 50 is generated by XORing 10 media packets 40 in the diagonal direction. A total of 121 packets which is the sum of 100 media packets 40 and 21 FEC packets 50 obtained by adding 10 FEC packets 50 in the row direction, 10 FEC packets 50 in the column direction, and one FEC packet 50 in the diagonal direction are transmitted as one unit and received by the TV 20.

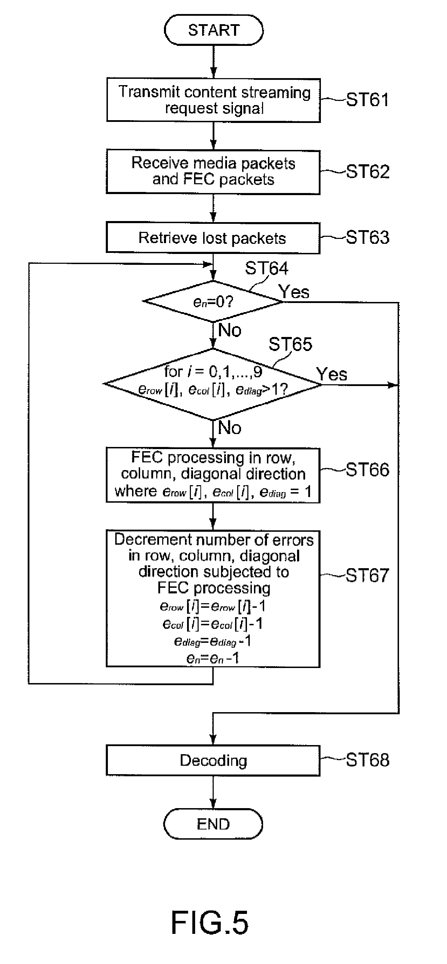

Next, an operation of the TV 20 will be described. Fig. 5 is a flowchart showing a flow of the operation of the TV 20.

As shown in this figure, first, when a manipulation of requesting watching and listening of the content is inputted, for example, from a manipulation input unit or the like, the CPU of the TV 20 transmits the content streaming request signal by the network interface 21 (Step 61), and receives by streaming the media packets 40 and FEC packets 50 transmitted from the server 10 in response to this request (Step 62). Subsequently, the CPU analyzes the UDP headers of the received packets and classifies the received packets into the media packets 40 and the FEC packets 50 by the UDP processor 22, and retrieves the lost media packets 40 based on the sequence numbers described in the RTP headers 43 of the media packets 40 by the FEC processor 23 (Step 63).

At this time, for example, by referring to the FEC headers 54 of the received FEC packets 50, the FEC processor 23 acquires respective parameters (DxL) of row and column counts of respective media packets protected by the FEC packets 50 and arranges the media packets 40 in rows and columns in accordance with these parameters. In this embodiment, the parameters are constituted by, for example, 10 rows and 10 columns.

Then, the FEC processor 23 finds values of a total loss count $e_n$, a loss count in each row $e_{row}[i]$ a loss count in each column $e_{col}[i]$, and a loss count in the diagonal direction ($A_1$ direction of Fig. 4) $e_{diag}$ of the media packets 40. Here, 0, 1, ... and 9 are substituted in order from the first to the tenth row and from the first to the tenth column into [i] of $e_{row}[i]$ and $e_{col}[i]$.

When the value of $e_n$ is 0 (Yes in Step 64), no media packet 40 is lost, whereby the FEC processor 23 demultiplexes the received media packets 40 into the video signal and the audio signal by the TS-DEMUX, decodes the video signal and the audio signal by the video TS decoder 26 and the audio TS decoder 27, and reproduces the decoded video signal and audio signal from the display 28 and the speaker 29 (Step 68).

When the value of $e_n$ is not 0 (No in Step 64), the FEC processor 23 confirms whether or not the values of $e_{row}[i]$, $e_{col}[i]$, and $e_{diag}$ are each 2 or more (Step 65). When the values are all 2 or more, it may be impossible to restore the media packets 40 using the FEC packets 50, and therefore the FEC processor 23 subjects the media packets 40 to decoding processing while the lost media packets 40 remain hidden (Step 68).

When the value of each of $e_{row}[i]$, $e_{col}[i]$, and $e_{diag}$ is 1 or less (No in Step 65), the FEC processor 23 executes restoration processing (hereinafter also referred to as FEC processing) of the media packet 40 using the FEC packet 50 from a place in which the value is 1 (Step 66). This processing will be specifically described below.

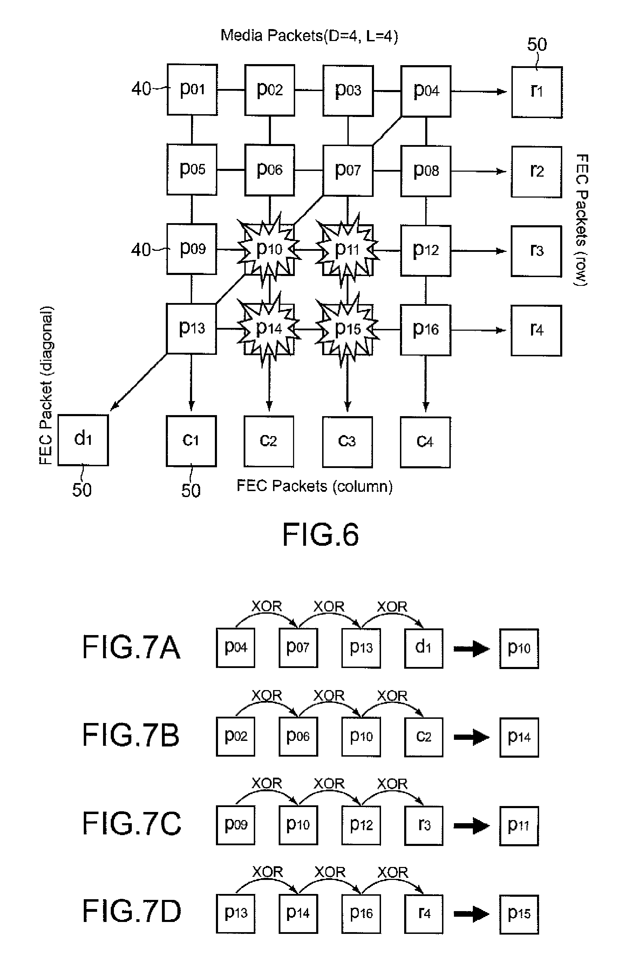

Fig. 6 is a diagram showing a state in which the media packets 40 are lost, and Fig. 7A to 7D are diagrams showing a manner in which the lost media packets 40 are restored. Incidentally, in these figures, for convenience of description, a case where the media packets 40 are arranged in four rows and four columns as in the above case of Fig. 4 is shown, but in the flowchart of Fig. 5, a description will be given assuming that the media packets 40 are arranged in 10 rows and 10 columns.

As shown in Fig. 6, for example, a case where four media packets 40 of media packets $p_{10}$, $p_{11}$, $p_{14}$, and $p_{15}$ are lost is assumed. In this case, the value of $e_{diag}$ out of $e_{row}[i]$, $e_{col}[i]$, and $e_{diag}$ becomes 1, whereby the FEC processor 23 first restores the media packet $p_{10}$ counted as $e_{diag} = 1$. More specifically, as shown in Fig. 7A, the media packet $p_{10}$ is restored by sequentially XORing the media packets $p_{04}$, $p_{07}$, $p_{13}$, and the FEC packet $d_1$ in the diagonal direction.

Then, as shown in Fig. 7B, the FEC processor 23 restores the media packet $p_{14}$ counted as $e_{col}[1] = 1$ by XORing the media packets $p_{02}$, $p_{06}$, $p_{10}$, and the FEC packet $c_2$ in the column direction.

Then, as shown in Fig. 7C, the FEC processor 23 restores the media packet $p_{11}$ counted as $e_{row}[2] = 1$ by XORing the media packets $p_{09}$, $p_{10}$, $p_{12}$, and the FEC packet $r_3$ in the row direction.

Then, as shown in Fig. 7D, the FEC processor 23 restores the media packet $p_{15}$ counted as $e_{row}[3] = 1$ by XORing the media packets $p_{13}$, $p_{14}$, $p_{16}$, and the FEC packet $r_4$ in the row direction.

Thus, all of the four lost media packets 40 are restored.

When restoring the media packets 40 one by one as just described, the FEC processor 23 decrements the respective values of loss counts $e_{row}[i]$, $e_{col}[i]$, and $e_{diag}$ in the row, column, and diagonal directions in which the media packet 40 restored by the above FEC processing is included, and correspondingly decrements the value of $e_n$ (Step 67). By repeating this processing until the value of $e_n$ becomes 0, the FEC processor 23 restores all the lost media packets 40 and decodes and reproduces the restored media packets 40 (Step 68).

As described above, according to this embodiment, when the media packets 40 are transmitted from the server 10 to the TV 20, the FEC packet 50 in the diagonal direction is also transmitted in addition to the FEC packets 50 in the row and column directions, so that the number of patterns of the media packets 40 which can be restored in the TV 20 can be greatly increased.

(Second Embodiment)

Next, a second embodiment of the present invention will be described. Incidentally, in this embodiment, the same numerals and symbols will be given to portions having the same constitutions and functions as those in the above first embodiment, and descriptions thereof will be omitted or simplified. Further, also in this embodiment, as in the first embodiment, the server 10 and the TV 20 constitute the error correcting system 100, and in the following description, operations of the server 10 and the TV 20 will be mainly described.

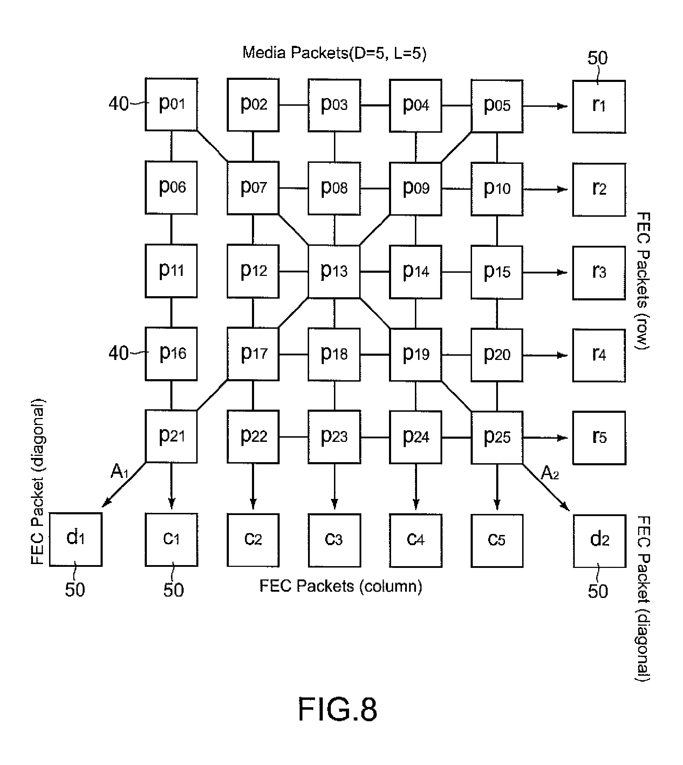

Fig. 8 is a diagram showing a manner in which the FEC processor 15 of the server 10 generates the FEC packets 50 in this embodiment. Incidentally, in this embodiment, for convenience of description, a case where the media packets 40 are arranged in five rows and five columns is shown, but in actuality, the FEC packets 50 are generated with the packets 40 in 10 rows and 10 columns as one unit as in the first embodiment. Needless to say, the numbers of rows and columns are not limited to these numbers of rows and columns.

As shown in this figure, the FEC processor 15 of the server 10 generates FEC packets $r_1$ to $r_5$ in the row direction, FEC packets $c_1$ to $c_5$ in the column direction, and one FEC packet $d_1$ in a diagonally downward left direction (direction of the arrow $A_1$). Moreover, in addition thereto, the FEC processor 15 generates one new FEC packet $d_2$ by sequentially XORing five media packets 40 of media packets $p_{01}$, $p_{07}$, $p_{13}$, $P_{19}$, and $p_{25}$ existing in a diagonally downward right direction (direction of the arrow $A_2$) orthogonal to the above direction of the arrow $A_1$.

The server 10 transmits 22 FEC packets 50 containing 10 FEC packets 50 in each of the row and column directions and the FEC packets 50 in the above two diagonal directions in addition to 100 media packets 40 in 10 rows and 10 columns to the TV 20.

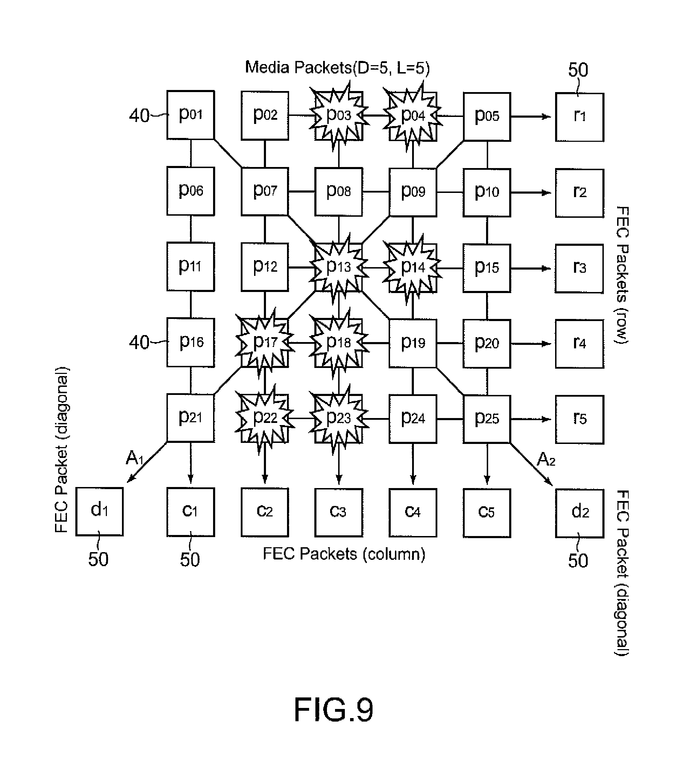

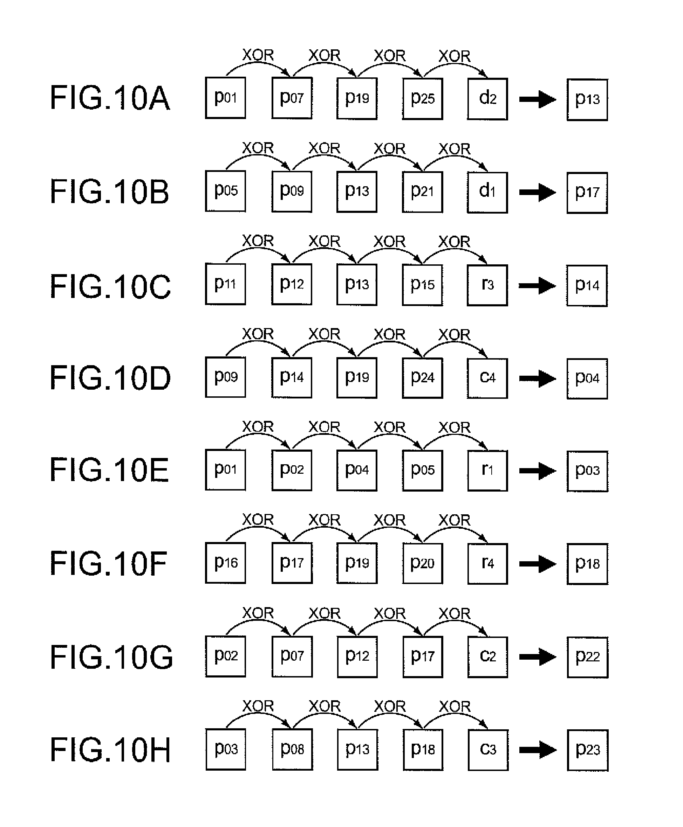

Fig. 9 is a diagram showing a state in which the media packets 40 transmitted from the server 10 are lost in the TV 20, and Figs. 10A to 10H are diagrams showing a manner in which the TV 20 restores the lost media packets 40.

As shown in Fig. 9, for example, a case where eight media packets 40 of media packets $p_{03}$, $p_{04}$, $p_{13}$, $p_{14}$, $p_{17}$, $p_{18}$, $p_{22}$, and $p_{23}$ are lost is assumed. In this case, the FEC processor 23 of the TV 20 finds loss counts $e_{row}[i]$, $e_{col}[i]$, and $e_{diag}$ of media packets in the row direction, the column direction, and the diagonal direction, respectively, as in the first embodiment. In this embodiment, there are two diagonal directions $A_1$ and $A_2$ (hereinafter referred to as a diagonal $A_1$ direction and a diagonal $A_2$ direction), and therefore the loss counts in the respective diagonal directions are taken as $e_{diag}[1]$ and $e_{diag}[2]$.

The value of $e_{diag}[2]$ out of $e_{row}[i]$, $e_{col}[i]$, and $e_{diag}$ becomes 1, so the FEC processor 23 first restores the media packet $p_{13}$ counted as $e_{diag}[2] = 1$. More specifically, as shown in Fig. 10A, the FEC processor 23 restores the media packet $p_{13}$ by sequentially XORing the media packets $p_{01}$, $p_{07}$, $p_{19}$, $p_{25}$ and the FEC packet $d_2$ in the diagonal $A_2$ direction.

Then, as shown in Fig. 10B, the FEC processor 23 restores the media packet $p_{17}$ counted as $e_{diag}[1] = 1$ by sequentially XORing the media packets $p_{05}$, $p_{09}$, $p_{13}$, $p_{21}$ and the FEC packet $d_1$ in the diagonal $A_1$ direction.

Then, as shown in Fig. 10C, the FEC processor 23 restores the media packet $p_{14}$ counted as $e_{row}[2] = 1$ by XORing the media packets $p_{11}$, $p_{12}$, $p_{13}$, $p_{15}$, and the FEC packet $r_3$ in the row direction.

Then, as shown in Fig. 10D, the FEC processor 23 restores the media packet $p_{04}$ counted as $e_{col}[3] = 1$ by XORing the media packets $p_{09}$, $p_{14}$, $p_{19}$, $p_{24}$, and the FEC packet $c_4$ in the column direction.

Then, as shown in Fig. 10E, the FEC processor 23 restores the media packet $p_{03}$ counted as $e_{row}[0] = 1$ by XORing the media packets $p_{01}$, $p_{02}$, $p_{04}$, $p_{05}$, and the FEC packet $r_1$ in the row direction.

Then, as shown in Fig. 10F, the FEC processor 23 restores the media packet $p_{18}$ counted as $e_{row}[3] = 1$ by XORing the media packets $p_{16}$, $p_{17}$, $p_{19}$, $p_{20}$, and the FEC packet $r_4$ in the row direction.

Then, as shown in Fig. 10G, the FEC processor 23 restores the media packet $p_{22}$ counted as $e_{col}[1] = 1$ by XORing the media packets $p_{02}$, $p_{07}$, $p_{12}$, $p_{17}$, and the FEC packet $c_2$ in the column direction.

Then, as shown in Fig. 10H, the FEC processor 23 restores the media packet $p_{23}$ counted as $e_{col}[2] = 1$ by XORing the media packets $p_{03}$, $p_{08}$, $p_{13}$, $p_{18}$, and the FEC packet $c_3$ in the column direction.

The above processing makes it possible to restore all of eight media packets 40 which cannot be restored by only the FEC packets in the row and column directions and the FEC packet $d_1$ in the diagonal $A_1$ direction in the first embodiment. In other words, according to this embodiment, the restoration rate of the lost media packets 40 can be further improved as compared with the

first embodiment.

Now, the number of patterns in which the media packets 40 become unrestorable will be considered by comparing the first and second embodiments described above with Pro-MPEG 2D FEC in the past.

As described above, in Pro-MPEG 2D FEC in the past (hereinafter referred to as the related art), the total number of transmitted packets obtained by summing the media packets 40 and the FEC packets 50 is 120. On the other hand, when one FEC packet $d_1$ in the diagonal $A_1$ direction is added in the above first embodiment, the total number of transmitted packets becomes 121, when one FEC packet $d_2$ in the diagonal $A_2$ direction is added in this embodiment, the total number of transmitted packets becomes 122, and in either case, the number of transmitted and received packets is increased only by about 1% as compared with the related art.

Moreover, in FEC processing in each of the related art, the first embodiment, and this embodiment, the number of patterns in which the lost media packets 40 become unrestorable can be expressed by a theoretical formula.

In the related art, when at least four media packets 40, two in each row and two in each column, forming vertexes of a rectangle are lost, the media packets 40 become unrestorable. Accordingly, if the numbers of rows and columns of the media packets 40 are assumed to be x and x respectively, the number of unrestorable patterns caused by the loss of four media packets 40 in the related art is expressed by the following theoretical formula.

$$_xC_2 \times _xC_2 \ \dots \ (1)$$

On the other hand, the number of unrestorable patterns in the first embodiment needs to eliminate patterns restorable by the FEC packet 50 in the diagonal direction from the number of patterns in the above related art. Regarding the number of patterns restorable by the FEC packet $d_1$ in the diagonal $A_1$ direction, paying attention first to one media packet 40 protected by the FEC packet $d_1$ in the diagonal $A_1$ direction, there are $_{x-1}C_1$ combinations in which the media packet 40 in the same row as the above media packet 40 is selected, there are $_{x-1}C_1$ combinations in which two media packets which form a rectangle in the same rows respectively as the above two media packets 40 are selected, and these combinations exist for each of the media packets 40 in the diagonal direction. Therefore, multiplying these values results in $_{x-1}C_1 \times _{x-1}C_1 \times x$ combinations. However, out of these combinations, there are $_xC_2$ overlapping combinations. Further, there are $_xC_2$ combinations in which if two media packets 40 in the diagonal direction are selected, these media packets become unrestorable. Hence, the number of unrestorable patterns in the first embodiment is expressed by the following theoretical formula.

$$_xC_2 \times _xC_2 - (_{x-1}C_1 \times _{x-1}C_1 \times x - _xC_2 \times 2) \ \dots \ (2)$$

Moreover, the number of unrestorable patterns in the second embodiment is found by further subtracting $_{x-1}C_1 \times _{x-1}C_1 \times x - _x(C_2 \times 2$ which is the number of patterns restorable by the FEC packet $d_2$ in the diagonal $A_2$ direction from the above formula (2). However, there are patterns overlapping with patterns restorable by the FEC packet $d_1$ in the diagonal $A_1$ direction, so it is necessary to eliminate the overlapping patterns.

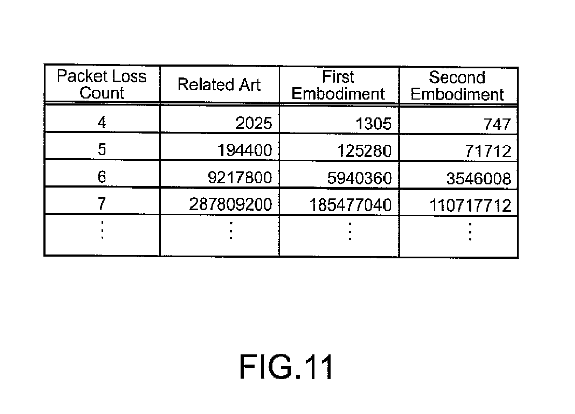

Fig. 11 is a table showing a comparison of the number of patterns in which the media packets 40 become unrestorable among the related art, the first embodiment, and the second embodiment by applying these theoretical formulas (1) and (2) to the media packets in 10 rows and 10 columns.

As shown in this figure, when the number of lost packets is four, the number of unrestorable patterns in the related art is 2025, whereas the number of unrestorable patterns in the first embodiment is 1305 and the number of unrestorable patterns in the second embodiment is 747. In other words, according to the first embodiment, the number of unrestorable patterns can be reduced to about 64% as compared with the related art, and according to the second embodiment, the number of unrestorable patterns can be reduced to about 37% as compared with the related art. Also when the number of lost packets is five or more, the same reduction rates as when the number of lost packets is four can be obtained in the respective embodiments. That is to say, according to the first and second embodiments, the restoration rate of the lost media packets 40 can be greatly improved with almost no increase in the number of transmitted and received packets.

(Third Embodiment)

Next, a third embodiment of the present invention will be described. Incidentally, in this embodiment, the same reference numerals and symbols will be given to portions having the same constitutions and functions as those in the above first and second embodiments, and descriptions thereof will be omitted or simplified. Further, also in this embodiment, as in the first and second embodiments, the server 10 and the TV 20 constitute the error correcting system 100, and in the following description, operations of the server 10 and the TV 20 will be mainly described.

In the above first and second embodiments, the media packets 40 are protected by one and two FEC packets 50, respectively. In these cases, however, the media packets 40 which are difficult to protect still exist. Hence, in this embodiment, the media packets 40 are protected by more FEC packets 50.

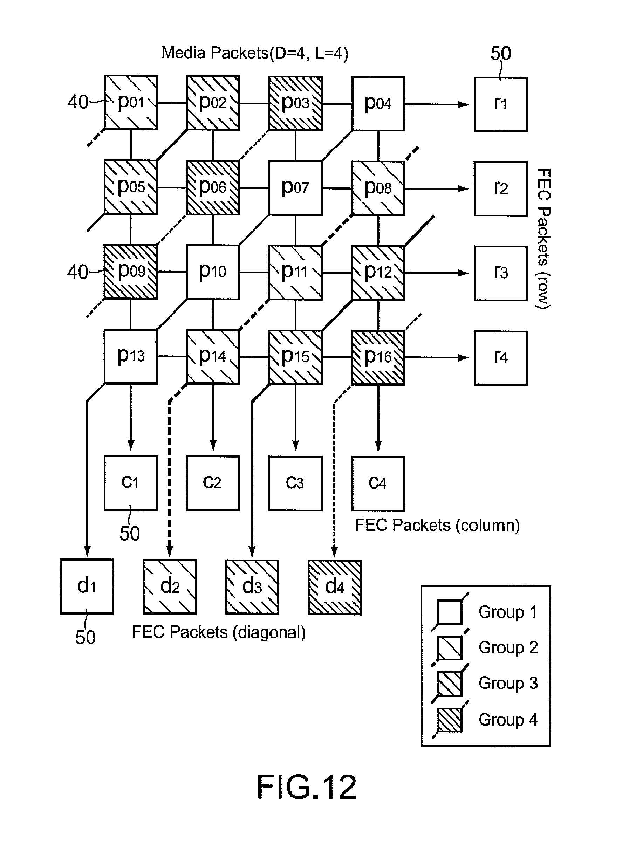

Fig. 12 is a diagram showing a manner in which the FEC processor 15 of the server 10 generates the FEC packets 50 in this embodiment. Incidentally, in this embodiment, for convenience of description, a state in which the media packets 40 are arranged in five rows and five columns is shown, but in actuality, the FEC packets 50 are generated with the media packets 40 in 10 rows and 10 columns as one unit as in the above first and second embodiments. Needless to say, the numbers of rows and columns are not limited to these numbers of rows and columns.

As shown in this figure, in this embodiment, the FEC processor 15 of the server 10 generates the FEC packets $r_1$ to $r_4$ in the row direction and the FEC packets $c_1$ to $c_4$ in the column direction by the same processing as in the first and second embodiments. Further, in addition to these FEC packets, the FEC processor 15 divides the media packets 40 into four groups (groups 1 to 4) in the diagonal direction and generates the FEC packet 50 for each of these groups.

More specifically, the FEC processor 15 classifies the media packets $p_{04}$, $p_{07}$, $p_{10}$, and $p_{13}$ as the group 1, the media packets $p_{01}$, $p_{08}$, $p_{11}$, and $p_{14}$ as the group 2, the media packets $p_{02}$, $p_{05}$, $p_{12}$, and $p_{15}$ as the group 3, and the media packets $p_{03}$, $p_{06}$, $p_{09}$, and $p_{16}$ as the group 4. Then, the FEC processor 15 performs XOR operations on the media packets 40 included in the respective groups to generate the FEC packets $d_1$ to $d_4$ for the respective groups.

Thus, all of the media packets 40 included in respective rows and respective columns are protected also by the FEC packets 50 in the diagonal direction. The server 10 transmits the above media packets 40, the FEC packets 50 in the row and column directions, and the above FEC packets 50 in the diagonal direction to the TV 20. In Fig. 12, the media packets 40 are arranged in four rows and four columns, but when the media packets 40 are arranged in D rows and L columns, the number of media packets 40 included in each group becomes L and the number of groups, that is, the number of FEC packets 50 in the diagonal direction becomes D. When the media packets 40 are arranged in 10 rows and 10 columns, the number of groups, the number of media packets 40 included in each group, and the number of FEC packets 50 in the diagonal direction each become 10, and the total number of transmitted packets becomes 130.

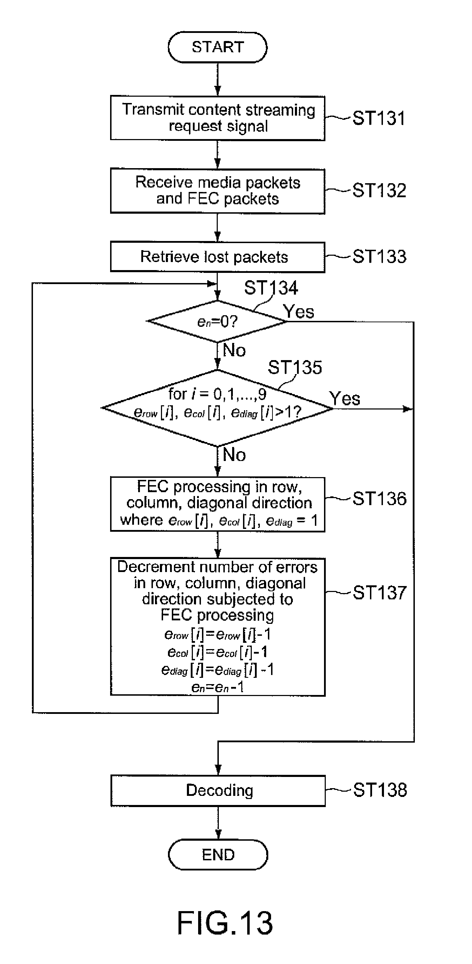

Fig. 13 is a flowchart showing a flow of an operation when the TV 20 receives and decodes the content in this embodiment. In this figure, descriptions of portions subjected to the same processing as in Fig. 5 of the above first embodiment will be omitted or simplified.

As shown in this figure, as in the case shown in Fig. 5 of the first embodiment, the CPU of the TV 20 transmits the content streaming request signal (Step 131), receives by streaming the media packets 40 and FEC packets 50 transmitted from the server 10 in response to this request (Step 132), and retrieves the lost media packets 40 based on the sequence numbers described in the RTP headers 43 of the received media packets 40 (Step 133).

Then, the FEC processor 23 finds values of a total loss count $e_n$, a loss count in each row $e_{row}[i]$, a loss count in each column $e_{col}[i]$, and a loss count in each group in the diagonal direction $e_{diag}[i]$ of the media packets 40. In $e_{diag}[i]$, [i] represents a group number. In this figure, the media packets 40 are assumed to be arranged in ten rows and ten columns. Accordingly, 0 to 9 are substituted into [i].

When the value of $e_n$ is 0 (Yes in Step 134), no media packet 40 is lost, whereby the FEC processor 23 decodes and reproduces the received media packets 40 as they are (Step 138).

When the value of $e_n$ is not 0 (No in Step 134), the FEC processor 23 confirms whether or not the values of $e_{row}[i]$, $e_{col}[i]$, and $e_{diag}[i]$ are each 2 or more (Step 135). When the values are all 2 or more, it may be impossible to restore the media packets 40 using the FEC packets 50, and therefore the FEC processor 23 subjects the media packets 40 to decoding processing while the lost media packets 40 remain hidden (Step 138).

When the value of each of $e_{row}[i]$, $e_{col}[i]$, and $e_{diag}$ is 1 or less (No in Step 135), the FEC processor 23 executes restoration processing of the media packet 40 from a row, a column, or a group in which the value is 1 (Step 136). This processing will be specifically described below.

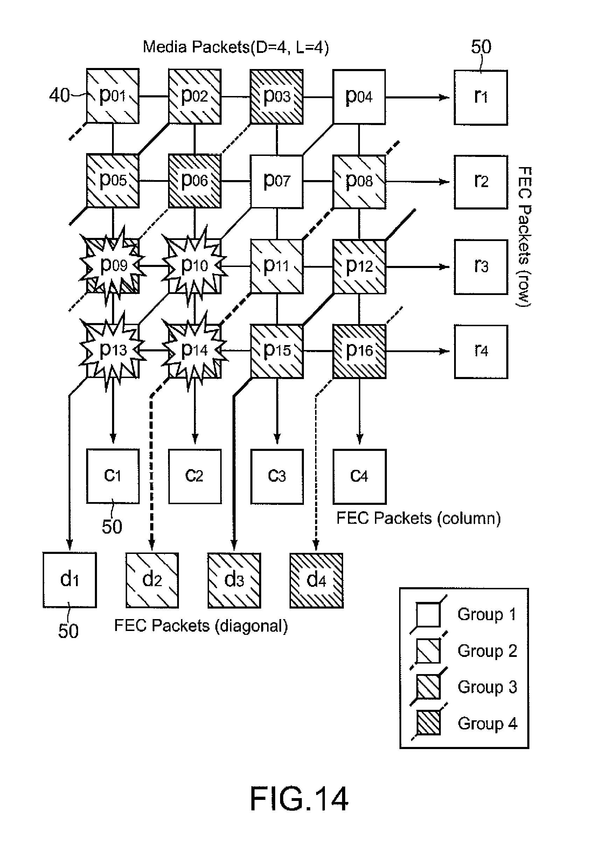

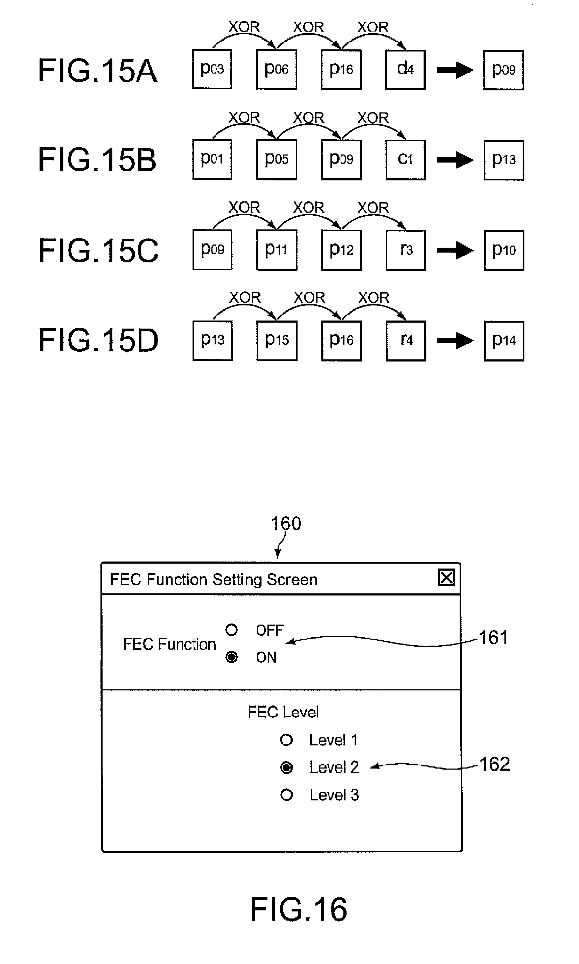

Fig. 14 is a diagram showing a state in which the media packets 40 are lost in this embodiment, and Fig. 15A to 15D are diagrams showing a manner in which the lost media packets 40 are restored. Incidentally, in these figures, for convenience of description, a case where the media packets 40 are arranged in four rows and four columns as in the above case of Fig. 12 is shown, but as described above, in the flowchart of Fig. 13, a description will be given assuming that the media packets 40 are arranged in 10 rows and 10 columns.

As shown in Fig. 14, for example, a case where four media packets 40 of media packets $p_{09}$, $p_{10}$, $p_{13}$, and $p_{14}$ are lost is assumed. In this case, the value of $e_{diag}[3]$ out of $e_{row}[i]$, $e_{col}[i]$, and $e_{diag}[i]$ becomes 1, whereby the FEC processor 23 first restores the media packet $p_{09}$ included in the group 4 and counted as $e_{diag}[3] = 1$. More specifically, as shown in Fig. 15A, the FEC processor 23 restores the media packet $p_{09}$ by sequentially XORing the media packets $p_{03}$, $p_{06}$, $p_{16}$, and the FEC packet $d_4$ in the diagonal direction.

Then, as shown in Fig. 15B, the FEC processor 23 restores the media packet $p_{13}$ counted as $e_{col}[0] = 1$ by XORing the media packets $p_{01}$, $p_{05}$, $p_{09}$, and the FEC packet $c_1$ in the column direction.

Then, as shown in Fig. 15C, the FEC processor 23 restores the media packet $p_{10}$ counted as $e_{row}[2] = 1$ by XORing the media packets $p_{09}$, $p_{11}$, $p_{12}$, and the FEC packet $r_3$ in the row direction.

Then, as shown in Fig. 15D, the FEC processor 23 restores the media packet $p_{14}$ counted as $e_{row}[3] = 1$ by XORing the media packets $p_{13}$, $p_{15}$, $p_{16}$, and the FEC packet $r_4$ in the row direction.

According to this embodiment, the above processing makes it possible to restore even the media packets 40 unrestorable in the above first embodiment. For example, in the above first embodiment, when the lost media packets form respective vertexes of a rectangle and two media packets 40 out of these four media packets are protected by the FEC packet 50 in the diagonal direction, these media packets 40 cannot be restored. In this embodiment, however, the media packets 40 are divided into a plurality of groups and all protected by the FEC packets for the respective groups, so that the restoration rate of the lost media packets 40 can be markedly improved as compared with the above first and second embodiments.

(Other Embodiments)

It should be noted that the present invention is not limited to the above embodiments, and various changes may be made therein without departing from the spirit of the present invention.

In the above first embodiment, one FEC packet 50 in the diagonal $A_1$ direction is added, and in the third embodiment, the protection level by the FEC packets 50 is further increased and a plurality of FEC packets 50 are added for a plurality of groups. However, it is also possible that a plurality of levels of FEC packets 50 coexist and FEC processing is selected from a plurality of levels of FEC processing and set on the TV 20 side.

Fig. 16 is a diagram showing a setting screen for a user of the TV 20 to select a level of FEC processing.

As shown in this figure, the CPU of the TV 20 causes the display 28 to display a FEC function setting screen 160, for example, in response to a user's manipulation input to the manipulation input unit. On this FEC function setting screen, a radio button 161 to set ON or OFF of an FEC function and a radio button 162 to set a level of the FEC function when the FEC function is ON are displayed.

By the user selecting ON or OFF of the FEC function via the manipulation input unit by the radio button 161, it can be selected in the TV 20 whether to restore the lost media packets 40 by performing the FEC processing and perform decoding processing of the content or perform the decoding processing while the lost media packets 40 remain hidden without performing the FEC processing.

When the FEC function is set to ON, it becomes possible to set, for example, three levels of FEC processing through the manipulation input unit by the radio button 162. For example, at a level 1, a setting is made such that FEC processing only in the row and column directions in Pro-MPEG 2D FEC of the related art is performed, at a level 2, a setting is made such that the FEC processing by the FEC packet 50 in the diagonal $A_1$ direction shown in the above first embodiment is performed, and at a level 3, a setting is made such that the FEC processing by the plurality of FEC packets 50 for the plurality of groups shown in the above third embodiment is performed.

Incidentally, in this case, the server 10 transmits the media packets 40 with the addition of the plurality of FEC packets 50 for the groups shown in the above third embodiment to the TV 20 at all times.

Thus, switching among the plurality of levels of FEC processing can be performed according to the user's request, for example, when the user wants to watch and listen the content in real time even if some packets are lost, when the user wants to watch and listen the content with a high image quality even if there is a slight delay, or when the user desires both of these cases, whereby the user's convenience is improved.

Further, for example, the CPU of the TV 20 may perform switching among the plurality of levels of FEC processing according to a time zone without using the above FEC function setting screen 160. For example, in a time zone (for example, nighttime hours) when the congestion of the network 30 is expected, it is expected that many media packets 40 become lost, whereby in this time zone, a setting can be made such that the FEC processing using the plurality of FEC packets 50 for the respective groups in the diagonal direction is performed, and in a time zone (for example, early-morning hours) when it is expected that the congestion of the network 30 is relatively relieved, a setting can be made such that the FEC processing by the FEC packets 50 only in the row and column directions in Pro-MPEG 2D FEC of the related art is performed.

Furthermore, the above plurality of levels of FEC packets 50 may be controlled, for example, according to the congestion status of the network 30 on the server 10 side. In other words, congestion information indicating the congestion status of the network 30 is previously transmitted from the TV 20 to the server 10, and the server 10 generates and transmits the above plurality of levels of FEC packets 50 according to the congestion information.

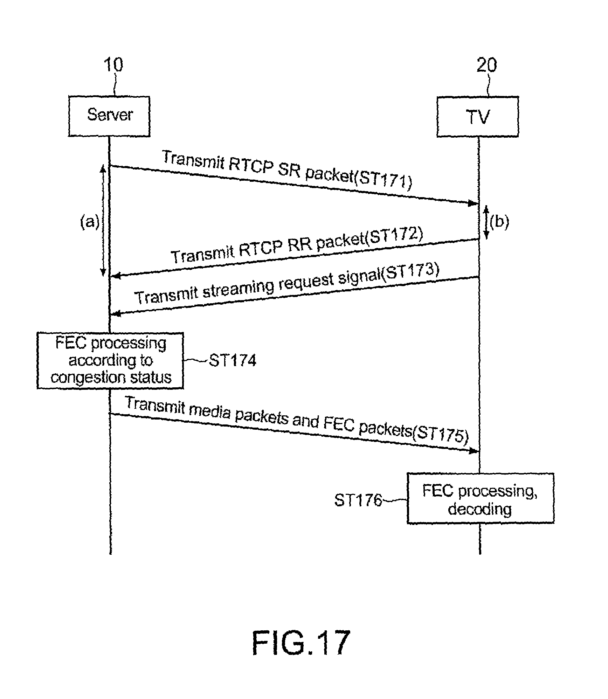

The FEC processing according to the congestion status can be realized, for example, by using session control technology using RTCP that is an RTP control protocol. The details of this operation will be described below. Fig. 17 is a sequence diagram showing a flow of this FEC processing according to the congestion status.

As shown in this figure, first, the server 10 transmits an RTCP SR (Sender Report) packet to the TV 20 (Step 171). In this SR packet, for example, the transmission state including the total number of transmitted packets up to this time of the server 10 as the transmitting source is described. On receipt of this SR packet, the TV 20 generates an RR (Receiver Report) packet and transmits the RR packet to the server 10 (Step 172). In this RR packet, a packet loss rate obtained from the SR pack-

et, a cumulative packet loss count up to this time, jitter of the arrival interval of a last received SR packet, a delay time from the reception of the last received SR packet to the transmission of this RR packet, and so on are described. Then, the TV 20 transmits a content streaming request signal to the server 10 (Step 173). Incidentally, the congestion information may be transmitted at a timing when the streaming request signal is transmitted.

When receiving the above RR packet and streaming request signal, the server 10 analyzes information such as the packet loss rate and jitter described in the RR packet and information such as an RTT (Round Trip Time) calculated by subtracting the delay time described in the RR (time represented by (b) in this figure) from the time from the transmission of the SR packet to the arrival of RP (time represented by (a) in this figure) as the congestion information of the network 30, and performs generation processing of the above plurality of levels of FEC packets 50 based on this congestion information (Step 174).

More specifically, the FEC processor 15 of the server 10 sets, for example, three levels (levels 1 to 3) in order of decreasing congestion degrees, when the congestion degree is judged to be, for example, level 1 according to the above congestion information, generates the plurality of FEC packets 50 for respective groups in the diagonal direction shown in the above third embodiment in addition to the FEC packets 50 in the row and column directions, when the congestion degree is judged to be level 2, generates the one FEC packet 50 in the diagonal $A_1$ direction shown in the above first embodiment in addition to the FEC packets 50 in the row and column directions, and when the congestion degree is judged to be level 3, generates the FEC packets 50 only in the row and column directions in Pro-MPEG 2D FEC of the related art. Incidentally, at this time, in the FEC headers 54 of the FEC packets 50, the above information indicating the level of the FEC packets 50 is described. Then, the server 10 transmits the generated FEC packets 50 and the media packets 40 to the TV 20 (Step 175).

The TV 20 receives these FEC packets 50 and media packets 40, and when the media packets 40 are lost, performs the FEC processing according to the above level by the FEC processor 23 (Step 176). That is to say, according to the level described in the above FEC headers 54, restoration processing of the media packets 40 using the FEC packets 50 in the row and column directions and one or the plurality of FEC packets 50 in the diagonal direction is performed. The restored media packets 40 are decoded and reproduced.

The above operation makes it possible to perform the generation processing of the FEC packets 50 according to the congestion status of the network 30 and the restoration processing of the media packets 40 therewith. Accordingly, it becomes possible to reduce the load on the server 10 related to the generation processing of the FEC packets 50 in the diagonal direction and the load on the TV 20 related to the restoration processing of the media packets 40 therewith to the minimum and efficiently restore the media packets 40 while preventing an increase in the number of transmitted packets caused by transmission of the FEC packets 50 in the diagonal direction as much as possible.

Incidentally, the number of the above FEC levels is not limited to three and, for example, by adding a case where two FEC packets 50 are generated by adding the FEC packet 50 in the diagonal $A_2$ direction shown in the above second embodiment as an additional level, the FEC processing may be switched among a total of four levels.

Further, more FEC packets 50 may be generated by performing the generation processing of the FEC packets 50 for the respective groups in the diagonal direction in the above third embodiment in the same manner also in a diagonal direction orthogonal to the above diagonal direction. Furthermore, it is also possible to set FEC processing using the FEC packets 50 for respective groups in both the diagonal directions as a new level.

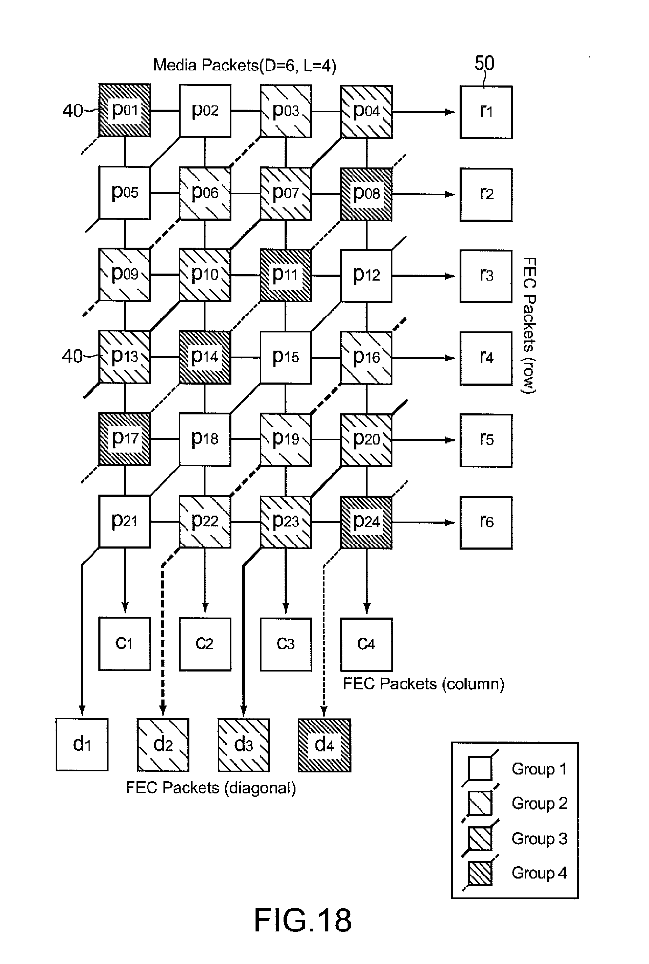

In the above respective embodiments, the example in which the numbers of rows and columns of the media packets 40 are the same is shown. However, the numbers of rows and columns may be, of course, different. Fig. 18 is a diagram showing a manner in which the server 10 generates the FEC packets 50 for respective groups in the diagonal direction in the above third embodiment when the numbers of rows and columns are different.

As shown in this figure, the media packets 40 are arranged, for example, in six rows and four columns. The FEC processor 15 of the server 10 classifies these media packets 40 into four (which is a number equal to the number of columns) groups, and out of these media packets 40, classifies six (which is a number equal to the number of rows) media packets $p_{02}$, $p_{05}$, $p_{12}$, $p_{15}$, $p_{18}$, and $p_{21}$ as a group 1, six media packets $p_{03}$, $p_{06}$, $p_{09}$, $p_{16}$, $p_{19}$, and $p_{22}$ as a group 2, six media packets $p_{04}$, $p_{07}$, $p_{10}$, $p_{13}$, $p_{20}$, and $p_{23}$ as a group 3, and six media packets $p_{01}$, $p_{08}$, $p_{11}$, $p_{14}$, $p_{17}$, and $p_{24}$ as a group 4. Then, the FEC processor 15 performs XOR operations on the media packets 40 included in the respective groups to generate FEC packets $d_1$ to $d_4$ for the respective groups. These FEC packets 50, together with other FEC packets 50 in the row and column directions and the media packets, are transmitted to the TV 20.

Then, the TV 20 arranges the received media packets in six rows and four columns described above, and performs the FEC processing for the respective groups using these FEC packets 50.

In the above embodiments, XOR operation processing is used for the generation processing of the FEC packets 50 and the restoration processing of the media packets 50 therewith, but operation processing using another function such as a Read-Solomon code or a Hamming code may be used.

In the above embodiments, the example in which the server 10 is used as the transmitting apparatus and the TV 20 as the receiving apparatus is shown, but in addition, these transmitting apparatus and receiving apparatus can be selected from all kinds of electronic apparatuses such as a PC, a recording/reproducing apparatus such as an HDD/DVD/BD (Blu-ray Disc) recorder, a game machine, a cellular phone handset, and other AV devices.

**Claims**

1. A transmitting apparatus, comprising:

   generating means (15) for generating first error correction packets by performing predetermined operation processing on a plurality of data packets arranged in a plurality of rows and columns respectively in each of the rows and columns and generating at least one second error correction packet by performing the predetermined operation processing on the data packets existing in a diagonal direction crossing the plurality of rows and columns; and
   transmitting means (17) for transmitting the plurality of data packets and the generated first and second error correction packets.

2. The transmitting apparatus as set forth in claim 1, wherein the generating means (15) generates the second error correction packets respectively by performing the predetermined operation processing respectively on a plurality of first data packets existing in a first diagonal direction and a plurality of second data packets existing in a second diagonal direction orthogonal to the first diagonal direction out of the plurality of data packets.

3. The transmitting apparatus as set forth in claim 1, wherein the plurality of data packets are arranged in D rows and L columns, and
   wherein the generating means (15) forms L groups each formed by extracting D data packets in the diagonal direction from the plurality of data packets and performs the predetermined operation processing on each of the L groups to generate the L second error correction packets.

4. The transmitting apparatus as set forth in claim 1, further comprising
   receiving means for receiving congestion information indicating a congestion status of a network from a receiving apparatus (20) connected via the network (30),
   wherein the generating means (15) includes means for regulating the generation of the second error correction packet based on the congestion information.

5. A receiving apparatus connected to a transmitting apparatus (10) via a network (30), comprising:

   receiving means (21) for receiving a plurality of data packets, first error correction packets, and at least one second error correction packet, the first error correction packets being generated by performing predetermined operation processing on the plurality of data packets arranged in a plurality of rows and columns respectively in each of the rows and columns, the second error correction packet being generated by performing the predetermined operation processing on the data packets existing in a diagonal direction crossing the plurality of rows and columns from the transmitting apparatus;
   specifying means (23) for specifying a lost data packet lost out of the plurality of data packets; and
   restoring means (23) for restoring the specified lost data packet using the first and second error correction packets.

6. The receiving apparatus as set forth in claim 5, wherein the restoring means (23) includes:

   means for arranging the received plurality of data packets in the plurality of rows and columns;
   means for detecting numbers of the lost data packets in a direction of each of the rows, a direction of each of the columns, and the diagonal direction;
   means for, when the number detected in the direction of each of the rows or direction of each of the columns is one, restoring the lost data packet by performing the predetermined operation processing on data packets other than the lost data packet in the direction of each of the rows or the direction of each of the columns and the first error correction packet; and
   means for, when the number detected in the diagonal direction is one, restoring the lost data packet by performing the predetermined operation processing on data packets other than the lost data packet in the diagonal direction and the second error correction packet.

7. The receiving apparatus as set forth in claim 5, wherein the received second error correction packets are respectively generated by performing the predetermined operation processing respectively on a plurality of first data packets existing in a first diagonal direction and a plurality of second data packets existing in a second diagonal direction orthogonal to the first diagonal direction out of the plurality of data packets arranged in the plurality of rows and columns in the transmitting apparatus.

8. The receiving apparatus as set forth in claim 5,

wherein the received second error correction packets are L second error correction packets generated by forming the L groups each formed by extracting D data packets in the diagonal direction from the plurality of data packets arranged in D rows and L columns and performing the predetermined operation processing on each of the L groups in the transmitting apparatus.

9. The receiving apparatus as set forth in claim 6, wherein the receiving means (21) receives a predetermined packet from the transmitting apparatus (10) before receiving the data packets, the receiving apparatus (20) further comprising:

generating means for generating congestion information indicating a congestion status of the network based on a reception status of the received predetermined packet; and transmitting means for transmitting the generated congestion information to the transmitting apparatus, and wherein the restoring means (23) includes means for, when the transmitting apparatus (10) regulates the generation and transmission of the second error correction packet based on the congestion information, regulating the detection of the number of the lost data packets in the diagonal direction.

10. The receiving apparatus as set forth in claim 5, further comprising:

input means for inputting a user's manipulation to select any of a first mode in which the lost data packet is restored using the first and second error correction packets, a second mode in which the lost data packet is restored using the first error correction packet, and a third mode in which the lost data packet is not restored; and setting means for setting any of the first to third modes according to the input.

11. An error correcting system comprising:

a transmitting apparatus (10) including

generating means (15) for generating first error correction packets by performing predetermined operation processing on a plurality of data packets arranged in a plurality of rows and columns respectively in each of the rows and columns and generating at least one second error correction packet by performing the predetermined operation processing on the data packets existing in a diagonal direction crossing the plurality of rows and columns, and

transmitting means (17) for transmitting the plurality of data packets and the generated first and second error correction packets; and

a receiving apparatus (20) including

receiving means (21) for receiving the transmitted plurality of data packets and the first and second error correction packets from the transmitting apparatus, specifying means (23) for specifying a lost data packet lost out of the plurality of data packets; and restoring means (23) for restoring the specified lost data packet using the first and second error correction packets.

12. A transmitting method, comprising:

generating first error correction packets by performing predetermined operation processing on a plurality of data packets arranged in a plurality of rows and columns respectively in each of the rows and columns; generating at least one second error correction packet by performing the predetermined operation processing on the data packets existing in a diagonal direction crossing the plurality of rows and columns, and transmitting the plurality of data packets and the generated first and second error correction packets.

13. An error correcting method, comprising:

receiving means for receiving a plurality of data packets, first error correction packets, and at least one second error correction packet, the first error correction packets being generated by performing predetermined operation processing on the plurality of data packets arranged in a plurality of rows and columns respectively in each of the rows and columns, the second error correction packet being generated by performing the predetermined operation processing on the data packets existing in a diagonal direction crossing the plurality of rows and columns from a transmitting apparatus connected via a network; specifying a lost data packet lost out of the plurality of data packets; and restoring the specified lost data packet using the first and second error correction packets.

FIG.1

EP 2 019 505 A2

START

Receive content streaming
request signal — ST31

Set frame number n to n = 1 — ST32

Compression-encode content — ST33

Generate RTP packets — ST34

Generate FEC packets — ST35

Packetization into
UDP packets — ST36

Transmit UDP packets — ST37

Set frame number
n to n = n+1 — ST38

ST39

No — Number of
all frames: N<n?

Yes

END

FIG.2

41  42  40  43  44

| IP | UDP | RTP | RTP Payload |

| IP | UDP | RTP | FEC | FEC Payload |

51  52  53  54  55

50

# FIG.3

Media Packets(D=4, L=4)

40 — p01  p02  p03  p04  →  r1

p05  p06  p07  p08  →  r2

40 — p09  p10  p11  p12  →  r3

p13  p14  p15  p16  →  r4

50

A₁

d1  C1  C2  C3  C4

50  50  FEC Packets (column)

FEC Packet (diagonal)

FEC Packets (row)

# FIG.4

START

Transmit content streaming request signal —ST61

Receive media packets and FEC packets —ST62

Retrieve lost packets —ST63

ST64
$e_n = 0$? —— Yes

No

ST65
for $i = 0, 1, ..., 9$
$e_{row}[i]$, $e_{col}[i]$, $e_{diag} > 1$? —— Yes

No

FEC processing in row, column, diagonal direction where $e_{row}[i]$, $e_{col}[i]$, $e_{diag} = 1$ —ST66

Decrement number of errors in row, column, diagonal direction subjected to FEC processing
$e_{row}[i] = e_{row}[i] - 1$
$e_{col}[i] = e_{col}[i] - 1$
$e_{diag} = e_{diag} - 1$
$e_n = e_n - 1$ —ST67

Decoding —ST68

END

FIG.5

Media Packets(D=4, L=4)

FIG.6

FIG.7A

FIG.7B

FIG.7C

FIG.7D

Media Packets(D=5, L=5)

FIG.8

FIG.9

FIG.10A

$$p_{01} \xrightarrow{XOR} p_{07} \xrightarrow{XOR} p_{19} \xrightarrow{XOR} p_{25} \xrightarrow{XOR} d_2 \Rightarrow p_{13}$$

FIG.10B

$$p_{05} \xrightarrow{XOR} p_{09} \xrightarrow{XOR} p_{13} \xrightarrow{XOR} p_{21} \xrightarrow{XOR} d_1 \Rightarrow p_{17}$$

FIG.10C

$$p_{11} \xrightarrow{XOR} p_{12} \xrightarrow{XOR} p_{13} \xrightarrow{XOR} p_{15} \xrightarrow{XOR} r_3 \Rightarrow p_{14}$$

FIG.10D

$$p_{09} \xrightarrow{XOR} p_{14} \xrightarrow{XOR} p_{19} \xrightarrow{XOR} p_{24} \xrightarrow{XOR} c_4 \Rightarrow p_{04}$$

FIG.10E

$$p_{01} \xrightarrow{XOR} p_{02} \xrightarrow{XOR} p_{04} \xrightarrow{XOR} p_{05} \xrightarrow{XOR} r_1 \Rightarrow p_{03}$$

FIG.10F

$$p_{16} \xrightarrow{XOR} p_{17} \xrightarrow{XOR} p_{19} \xrightarrow{XOR} p_{20} \xrightarrow{XOR} r_4 \Rightarrow p_{18}$$

FIG.10G

$$p_{02} \xrightarrow{XOR} p_{07} \xrightarrow{XOR} p_{12} \xrightarrow{XOR} p_{17} \xrightarrow{XOR} c_2 \Rightarrow p_{22}$$

FIG.10H

$$p_{03} \xrightarrow{XOR} p_{08} \xrightarrow{XOR} p_{13} \xrightarrow{XOR} p_{18} \xrightarrow{XOR} c_3 \Rightarrow p_{23}$$

| Packet Loss Count | Related Art | First Embodiment | Second Embodiment |
|---|---|---|---|
| 4 | 2025 | 1305 | 747 |
| 5 | 194400 | 125280 | 71712 |
| 6 | 9217800 | 5940360 | 3546008 |
| 7 | 287809200 | 185477040 | 110717712 |
| ⋮ | ⋮ | ⋮ | ⋮ |

# FIG.11

Media Packets(D=4, L=4)

FIG.12

START

Transmit content streaming
request signal — ST131

Receive media packets
and FEC packets — ST132

Retrieve lost packets — ST133

ST134

$e_n = 0$? — Yes

No

ST135

for $i = 0, 1, \ldots, 9$
$e_{row}[i]$, $e_{col}[i]$, $e_{diag}[i] > 1$? — Yes

No

FEC processing in row,
column, diagonal direction
where $e_{row}[i]$, $e_{col}[i]$, $e_{diag} = 1$ — ST136

Decrement number of errors
in row, column, diagonal
direction subjected to
FEC processing
$e_{row}[i] = e_{row}[i] - 1$
$e_{col}[i] = e_{col}[i] - 1$
$e_{diag}[i] = e_{diag}[i] - 1$
$e_n = e_n - 1$ — ST137

Decoding — ST138

END

FIG.13

Media Packets(D=4, L=4)

FIG.14

FIG.15A

$p_{03}$ --XOR--> $p_{06}$ --XOR--> $p_{16}$ --XOR--> $d_4$ ➡ $p_{09}$

FIG.15B

$p_{01}$ --XOR--> $p_{05}$ --XOR--> $p_{09}$ --XOR--> $c_1$ ➡ $p_{13}$

FIG.15C

$p_{09}$ --XOR--> $p_{11}$ --XOR--> $p_{12}$ --XOR--> $r_3$ ➡ $p_{10}$

FIG.15D

$p_{13}$ --XOR--> $p_{15}$ --XOR--> $p_{16}$ --XOR--> $r_4$ ➡ $p_{14}$

160

| FEC Function Setting Screen | ☒ |
|---|---|

FEC Function    ○ OFF    161
                ◉ ON

FEC Level
        ○ Level 1
        ◉ Level 2    162
        ○ Level 3

FIG.16

10
Server

20
TV

Transmit RTCP SR packet(ST171)

(a)

(b)

Transmit RTCP RR packet(ST172)

Transmit streaming request signal(ST173)

FEC processing
according to
congestion status ——ST174

Transmit media packets and FEC packets(ST175)

ST176—— FEC processing,
decoding

FIG.17

Media Packets(D=6, L=4)

50

40 — p01 p02 p03 p04 → r1

p05 p06 p07 p08 → r2

p09 p10 p11 p12 → r3

40 — p13 p14 p15 p16 → r4

p17 p18 p19 p20 → r5

p21 p22 p23 p24 → r6

FEC Packets (row)

c1 c2 c3 c4

FEC Packets (column)

d1 d2 d3 d4

FEC Packets (diagonal)

| | Group 1 |
| | Group 2 |
| | Group 3 |
| | Group 4 |

FIG.18

**EP 2 019 505 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007182294 A
- JP 2007509557 A